# DEMANDE DE BREVET EUROPEEN

(11) **EP 2 669 932 A1**
(43) Date de publication de la demande: **04.12.2013**
(21) Numéro de dépôt: 13169110.7
(22) Date de dépôt: 24.05.2013
(51) Int. Cl.: H01L 21/033, H01L 21/308, H01L 29/786, H01L 29/66

(54) **Procede de fabrication de transistor comprenant des motifs nanometriques semiconducteurs utilisant des copolymeres a blocs**

(30) Priorité: 30.05.2012 FR 1254960
(71) Demandeur: COMMISSARIAT A L'ENERGIE ATOMIQUE ET AUX ENERGIES ALTERNATIVES, 75015 Paris (FR)
(72) Inventeur: Morvan, Siméon, 38000 GRENOBLE (FR); Andrieu, François, 38000 GRENOBLE (FR); Tiron, Raluca, 38950 SAINT-MARTIN-LE-VINOUX (FR)
(74) Mandataire: Esselin, Sophie

(57) **Abrégé**

L'invention a pour objet un procédé de fabrication d'au moins un transistor comportant une zone active semiconductrice sur ou dans un substrat, ladite zone active semiconductrice comprenant une zone de source, une zone de drain et une zone de canal recouverte d'une grille permettant la circulation d'un courant entre la zone de source et la zone de drain selon une première direction X caractérisé en ce qu'il comprend :
- la réalisation d'un masque de gravure primaire à la surface de la zone semiconductrice, ledit masque présentant au moins une ouverture primaire (Opᵢ) de dimensions Lₓ et Ly dans un plan défini par une première direction X et par une seconde direction Y, parallèles au plan de ladite zone semiconductrice ;
- le dépôt d'un copolymère bloc présentant une alternance d'au moins des premiers motifs de polymère (A) et des seconds motifs de polymère (B) dans ladite ouverture primaire, lesdits premiers et seconds motifs de polymère étant respectivement de dimensions Lₓ et L_{yA} et Lₓ et L_{yB}, les dimensions L_{yA} et L_{yB} étant des dimensions nanométriques ;
- le retrait d'une des séries de premiers motifs ou de seconds motifs de polymère de manière à créer un masque secondaire présentant des ouvertures secondaires (Osᵢ) réparties selon la seconde direction Y ;
- la gravure de ladite zone active au travers desdites ouvertures secondaires de manière à définir les motifs auto-alignés semiconducteurs dans la zone de canal selon la seconde direction Y (12ij) de taille nanométrique de dimensions Lₓ et L_{yA} ou Lₓ et L_{yB}, répartis le long de ladite seconde direction Y ;
- la réalisation de ladite grille à la surface desdits motifs auto-alignés semiconducteurs.

## Description

Le domaine de l'invention est celui des composants semiconducteurs et des technologies permettant de définir des motifs de très petites dimensions afin de pouvoir réaliser des composants tels que par exemple des transistors et pouvant être par exemple des transistors FDSOI, c'est-à-dire des transistors complètement désertés.

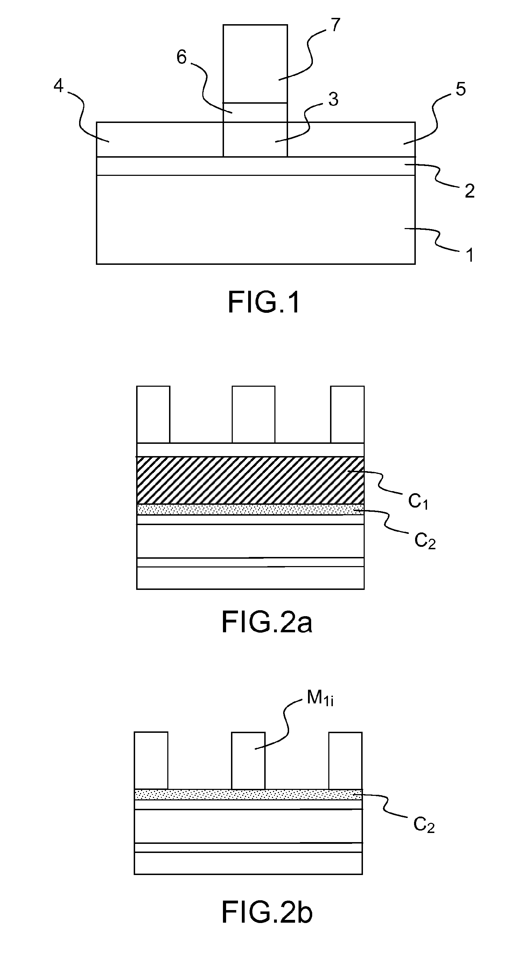

Un exemple de transistor FDSOI est illustré en figure 1. Ce type de transistor est réalisé sur un substrat de type SOI, acronyme de « Silicon On Insulator », correspondant à une structure constituée d'un empilement d'une couche de silicium (de quelques nm à quelques dizaines de nm d'épaisseur) sur une couche de diélectrique pouvant être du dioxyde de silicium et formant ainsi une couche de diélectrique enterrée, couramment dénommée BOX. Le substrat SOI comporte ainsi un substrat en silicium 1, la couche enterrée BOX 2 et une couche de semiconducteur, tel que le silicium par exemple dans laquelle sont réalisés un canal 3, une région de source 4 et une région de drain 5. Le canal 3 est recouvert d'un diélectrique de grille 6, sur lequel est disposée la grille 7.

Concernant ce type de composants, il est de plus en plus difficile et coûteux d'obtenir des motifs de petites tailles en utilisant la lithographie optique conventionnelle.

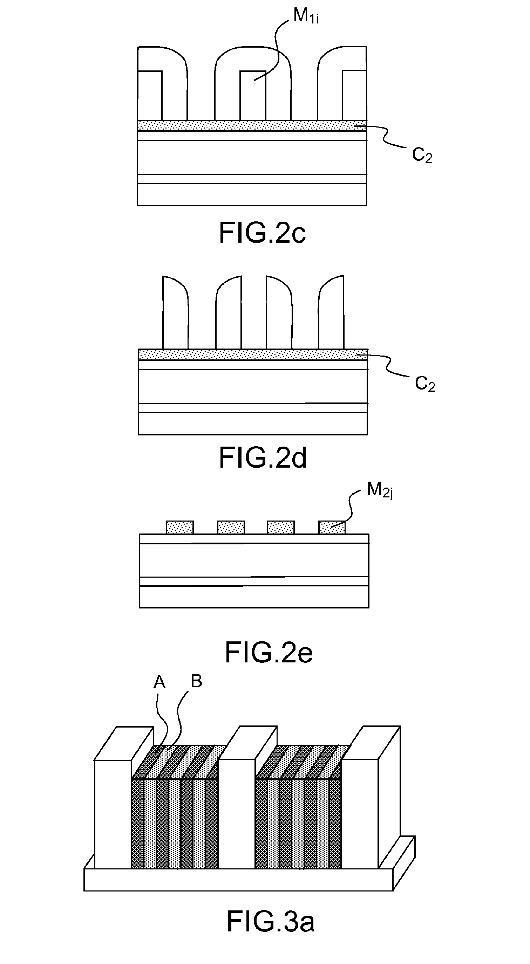

Plusieurs solutions sont envisagées pour les futurs noeuds technologiques :
- conserver la même technique de lithographie mais en diminuant les longueurs d'onde utilisées (extrême UV technologie...) ;
- se baser sur un ou plusieurs faisceaux d'électrons ;
- utiliser des astuces de type « double patterning » utilisant par exemple des espaceurs comme masque afin de doubler la densité des motifs comme illustré par l'ensemble des différentes étapes de procédé illustrées grâce aux figures 2a à 2e, montrant par des opérations successives de lithographie, la possibilité d'inclure successivement dans différentes couches C₁ et C₂ des motifs de plus en plus petits, respectivement M₁ᵢ et M₂ⱼ.

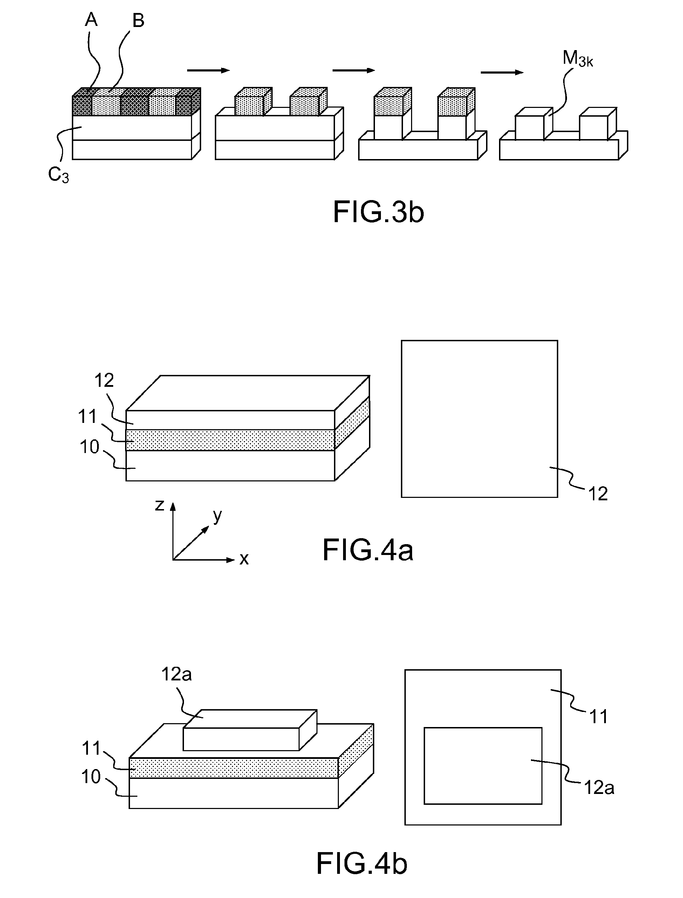

II a déjà également été proposé d'utiliser des copolymères dits à blocs. Sous certaines conditions (rapport des masses molaires, taille et passivation des cavités), les copolymères à blocs dénommés BCP, peuvent être organisés en lamelles formées alternativement par des monomères de type A et B, comme représenté en figure 3a. En enlevant uniquement un des deux types de blocs B, il est possible d'utiliser le bloc restant A comme un masque à la gravure, comme illustré en figure 3b. Des motifs denses M₃ₖ de la taille des blocs sont alors transférés dans le matériau sous jacent de la couche C₃.

Ce type de structure est notamment décrit dans les brevets WO 2011 74852 A1 permettant de définir des nanostructures conductrices par retrait successifs d'une première série de blocs, puis d'une seconde série de blocs, ou bien encore dans les demandes de brevet US 2011 0117744 A1 ou US 2011 0081777A1.

Certaines publications scientifiques divulguent également des procédés permettant de réaliser des motifs pour des structures de transistors et notamment les articles de L.-W. Cheng et al.; " Top-gated FETs/inverters with diblock copolymer self-assembled 20 nm contact holes "; IEDM; p. 1-4, 2009 ou bien encore, celle de L.-W. Cheng et al.: " Experimental demonstration of aperiodic patterns of directed self-assembly by block copolymer lithography for random logic circuit layout ", IEDM; p. 33.2.1 - 33.2.4; 2010. Dans cette publication les copolymères sont auto-assemblés pour former des trous de 18nm de diamètre. Ces trous sont remplis avec du platine afin de créer des contacts. Les performances électriques d'un inverseur CMOS réalisé avec cette technique sont également présentées.

Dans ce contexte, le Demandeur propose un nouveau procédé permettant l'obtention de structure semiconductrice originale comprenant des motifs de matériau semiconducteur de très petites dimensions et auto-alignés. Avantageusement ce type de procédé peut permettre de réaliser des transistors intégrant des grilles de transistor dites « tri-grille » en raison de leur définition dans les trois dimensions, rendues possibles grâce notamment à l'utilisation de copolymères à blocs BCP et permettant d'obtenir un meilleur contrôle électrostatique et un encombrement plus faible.

Plus précisément l'invention a pour objet un procédé de fabrication d'au moins un transistor comportant une zone active semiconductrice sur ou dans un substrat, ladite zone active semiconductrice comprenant une zone de source, une zone de drain et une zone de canal recouverte d'une grille permettant la circulation d'un courant entre la zone de source et la zone de drain selon une première direction X **caractérisé en ce qu'il** comprend :
- la réalisation d'un masque de gravure primaire à la surface de la zone active semiconductrice, ledit masque présentant au moins une ouverture primaire de dimensions Lₓ et L_{y} dans un plan défini par une première direction X et par une seconde direction Y, parallèles au plan de ladite zone semiconductrice ;
- le dépôt d'un copolymère bloc présentant une alternance d'au moins des premiers motifs de polymère (A) et des seconds motifs de polymère (B) dans ladite ouverture primaire, lesdits premiers et seconds motifs de polymère étant respectivement de dimensions Lₓ et L_{yA} et Lₓ et L_{yB}, les dimensions L_{yA} et L_{yB} étant des dimensions nanométriques ;
- le retrait d'une des séries de premiers motifs ou de seconds motifs de polymère de manière à créer un masque secondaire présentant des ouvertures secondaires réparties selon la seconde direction Y ;
- la gravure de ladite zone active au travers desdites ouvertures secondaires de manière à définir les motifs auto-alignés semiconducteurs dans la zone de canal selon la seconde direction Y de taille nanométrique de dimensions Lₓ et L_{yA} ou Lₓ et L_{yB}, répartis le long de ladite seconde direction Y;
- la réalisation de ladite grille à la surface desdits motifs auto-alignés semiconducteurs.

Selon une variante de l'invention, la réalisation du masque primaire comprend les étapes suivantes :
- la réalisation d'au moins un motif primaire à la surface de ladite zone active;
- la réalisation d'espaceurs diélectriques en contact avec ledit motif primaire ;
- le retrait dudit motif primaire par gravure sélective par rapport aux espaceurs diélectriques, lesdits espaceurs diélectriques définissant ledit masque primaire avec au moins ladite ouverture primaire.

Selon une variante de l'invention, la zone active est en silicium, ou en silicium-germanium, ou en germanium ou en matériau de type III-V pouvant être du InGaAs ou du InAs.

Selon une variante de l'invention, la zone active est réalisée dans une couche de matériau semiconducteur pouvant être en silicium à la surface d'une couche d'oxyde à la surface d'un substrat pouvant être en silicium.

Selon une variante de l'invention, la zone active est réalisée dans un substrat massif de matériau semiconducteur.

Selon une variante de l'invention, le copolymère est un copolymère dibloc composé de polystyrène (PS) et de poly (méthylméthacrylate) (PMMA).

Selon une variante de l'invention, le procédé comporte une étape de dépôt(s) d'oxyde(s) de grille, dont un dépôt d'oxyde de grille peut être réalisé de manière conforme sur lesdits motifs semiconducteurs.

Selon une variante de l'invention, le procédé comprend le dépôt d'une couche de métal de grille sur l'oxyde de grille, sur lesdits motifs auto-alignés semiconducteurs dans la zone de canal.

Selon une variante de l'invention, le procédé comprend le dépôt d'un matériau épais conducteur pouvant être en métal ou en silicium polycristallin à la surface de ladite couche de métal de grille.

Selon une variante de l'invention, le procédé comporte :
- le dépôt d'oxyde de grille sur ladite zone active au niveau de ladite zone de canal ;
- la réalisation d'au moins un motif primaire à la surface de ladite zone active;
- la réalisation d'espaceurs diélectriques en contact avec ledit motif primaire ;
- le retrait dudit motif primaire par gravure sélective par rapport aux espaceurs diélectriques, lesdits espaceurs diélectriques définissant ledit masque primaire avec au moins une ouverture primaire, ladite ouverture primaire étant située sur ledit oxyde de grille.

Selon une variante de l'invention, le procédé comprend le retrait dudit oxyde de grille et le dépôt postérieur d'un oxyde de grille réalisé de manière conforme sur lesdits motifs semiconducteurs auto-alignés.

Ainsi, il est possible de réaliser l'oxyde de grille de plusieurs façons et notamment :
- l'oxyde peut être déposé en début de process sur la zone active ;
- l'oxyde de grille peut être déposé de manière conforme par-dessus les motifs nanométriques auto-alignés et l'oxyde réalisé préalablement ;
- l'oxyde déposé préalablement peut être retiré, puis un oxyde de grille conforme peut être déposé.

Selon une variante de l'invention, le procédé comprend une étape de définition de ladite zone active destinée à correspondre à l'ensemble zone de source, zone de canal et zone de drain, par gravure dans un substrat massif de semiconducteur ou dans une couche semiconductrice à la surface d'une couche d'oxyde (BOX) à la surface d'un substrat.

Selon une variante de l'invention, le procédé comprend la réalisation de motifs de matériau isolant (STI), afin de définir ladite zone semiconductrice comprenant la zone de source, de la zone de drain et des motifs semiconducteurs auto-alignés recouverts, dans un substrat semiconducteur ou dans une couche semiconductrice à la surface d'une couche d'oxyde (BOX) à la surface d'un substrat

Selon une variante de l'invention, ledit motif primaire est éliminé par gravure chimique.

Selon une variante de l'invention, le procédé comprend le dépôt d'une couche de matériau isolant, enrobant l'ensemble de la zone de source, de la zone de drain et des motifs semiconducteurs auto-alignés recouverts.

Selon une variante de l'invention, le procédé comprend en outre la réalisation d'un série de plots individuels de contact électrique ou d'un ensemble linéaire de contact électrique au travers de ladite couche de matériau isolant, lesdits plots ou ledit ensemble linéaire de contacts permettant de contacter les sources et drains et commander lesdits motifs semiconducteurs auto-alignés.

L'invention sera mieux comprise et d'autres avantages apparaîtront à la lecture de la description qui va suivre donnée à titre non limitatif et grâce aux figures annexées parmi lesquelles :
- la figure 1 illustre un schéma de transistor de type FDSOI ;
- les figures 2a à 2e illustrent les différentes étapes d'un procédé selon l'art connu permettant l'obtention de motifs de petite taille ;
- les figures 3a et 3b sont relatives à l'utilisation de copolymère de type bloc et aux différentes étapes de traitement pouvant être réalisées sur un copolymère de type bloc selon l'art connu ;
- les figures 4a à 4m illustrent les différentes étapes d'un exemple de procédé selon l'invention permettant d'obtenir des transistors FDSOI de très petites dimensions et la figure 4n une variante de la figure 4m ;
- la figure 5 illustre une variante de l'étape de délimitation d'une zone active, par réalisation de motifs STI ;
- la figure 6 illustre une étape de réalisation de transistor comprenant la réalisation des éléments STI illustrés en figure 5 ;
- la figure 7 illustre une variante de réalisation de transistor ne comprenant pas de couche enterrée d'oxyde.

Le Demandeur propose un procédé original permettant d'intégrer les avantages offerts par les copolymères dits à bloc et ce pour réaliser des motifs semiconducteurs de taille nanométrique. Ce type de motifs peut être particulièrement intéressant pour être intégré dans un flow FDSOI CMOS, permettant en effet de définir comme il sera explicité plus en détails ci-après des éléments de canal et de grille de taille très petite et particulièrement bien isolés.

Les copolymères à blocs permettent en particulier d'obtenir des motifs de très petite taille avec une densité élevée et ce de manière auto-alignée. Dans la présente invention, les copolymères à blocs peuvent avantageusement être utilisés comme masque de gravure pour définir des « doigts » entre la source et le drain dans la zone active de transistors pour des noeuds technologiques avancés (inférieur à 22nm). Les transistors ainsi formés sont de type « tri-gate » : ils possèdent un meilleur contrôle électrostatique et un encombrement plus faible.

Il a notamment été montré dans différentes publications qu'un copolymère dibloc intégrant un composé de polystyrène (PS) et le poly (méthylméthacrylate) (PMMA) permettait d'obtenir une microphase de PS-PMMA pouvant être structurée en un réseau ordonné de taille nanométrique, caractéristique obtenue avec des conditions appropriées de recuit.

Ainsi en éliminant sélectivement des blocs de PMMA, on peut conserver des blocs de PS en ayant défini un réseau de lamelles, espacées d'une dizaine de nanomètres.

La présente invention propose ainsi d'utiliser avantageusement ces propriétés et grâce à la réalisation de masque multiples, de définir des motifs semiconducteurs auto-alignés de très petite taille dans une tranchée préalablement définie.

Sans constituer une restriction des applications envisageables, la présente invention va être décrite ci-après dans le cadre d'un exemple de procédé de fabrication de transistor FDSOI.

### Exemple de procédé de fabrication d'un transistor FDSOI selon l'invention :

L'ensemble des étapes sont illustrées grâce aux figures 4a à 4m.

A partir d'un substrat SOI, illustré en figure 4a et comportant un substrat massif 10, une couche d'oxyde enterré dit BOX 11 et une fine couche de silicium 12, on définit au sein de l'ensemble SOI, une zone active 12a dans un plan défini par les deux directions X et Y perpendiculaires à une direction Z comme représenté en figure 4b.

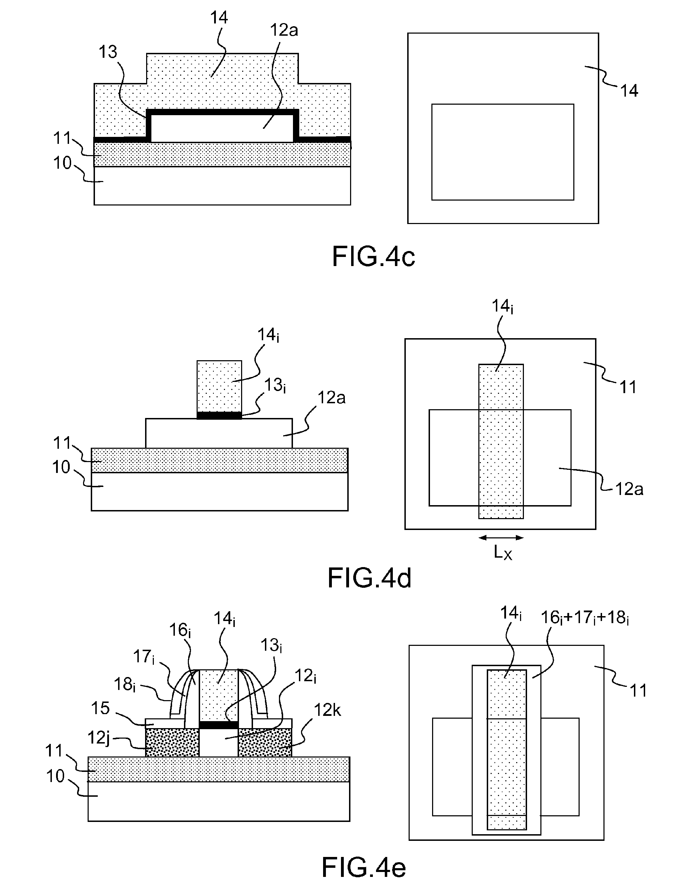

Selon la présente variante, et comme illustré en figure 4c, on vient réaliser le dépôt d'une fine couche d'oxyde 13, typiquement cette couche peut être en SiO₂ ou en HfO₂, ou tout autre oxyde, puis, on procède au dépôt d'une couche en matériau 14 présentant une bonne sélectivité à la gravure chimique par rapport à d'autres matériaux comme il sera détaillé ultérieurement dans la présente description, ce matériau pouvant typiquement être du silicium polycristallin.

On procède à la gravure des couches 13 et 14, comme illustré en figure 4d, de manière à définir les motifs primaires 13i,14i qui correspondront aux ouvertures du masque primaire. Typiquement la dimension Lₓ de ces motifs peut être comprise dans les technologies classiques entre environ une dizaine de nanomètres et une dizaine de microns.

On réalise par implantation, des zones de source 12j et de drain 12k dans la zone active 12a, par dopage de par et d'autre d'une zone destinée à être une zone de canal 12i, comme illustré en figure 4e. On réalise de part et d'autres des motifs primaires 13i,14i, des espaceurs diélectriques avec un matériau diélectrique pouvant être en nitrure. Avantageusement, il peut s'agir d'une combinaison de nitrure 16i, de matériau de tétraéthoxysilane Si(OC₂H₅)₄ encore dénommé TEOS, 17i et de nitrure 18i comme représenté en figure 4e, les dopages des zones 12j et 12k, pouvant être renforcés au niveau d'une couche supplémentaire plus fortement dopée 15.

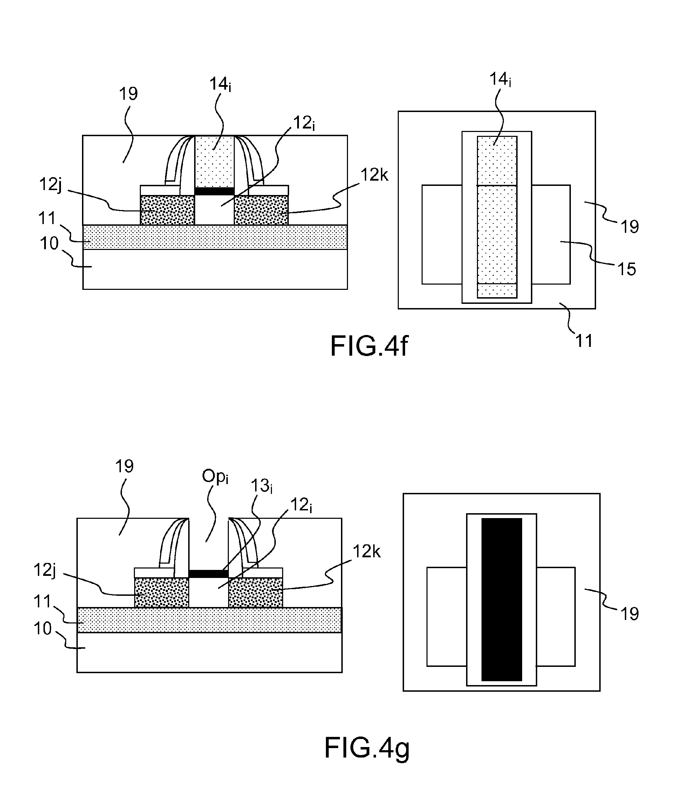

On vient recouvrir l'ensemble, d'une couche épaisse de diélectrique 19 comme illustré en figure 4f.

On élimine sélectivement les motifs primaires 14i par gravure, par exemple par gravure chimique sélective en raison de la différence de comportement à la gravure entre le silicium polycristallin et le nitrure de manière à définir un masque primaire avec des ouvertures dites primaires Opᵢ, avec arrêt de la gravure au niveau de l'élément 13i (ou 12i), comme représenté en figure 4g.

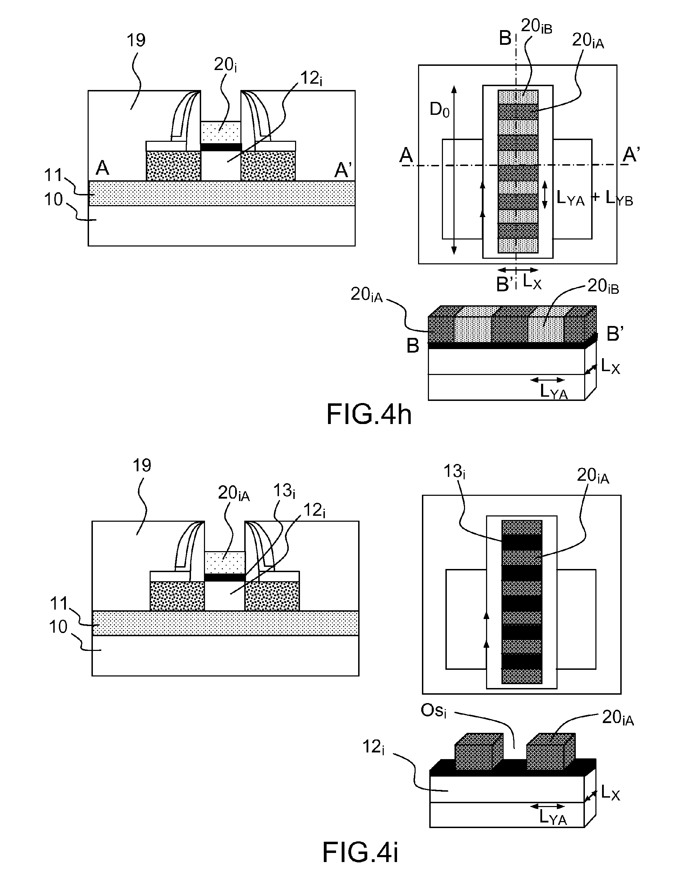

On procède alors au dépôt de la couche 20i de copolymère structuré comme illustré en figure 4h, dans les ouvertures Opᵢ, préalablement réalisées. La couche de copolymère est constituée plus précisément de blocs 20i_{A} et 20i_{B}, comme représenté en vue de dessus en figure 4h, les dimensions des blocs selon la direction Y, L_{YA} et L_{YB} sont typiquement de l'ordre de quelques dizaines de nanomètres. La distance D₀ est ainsi définie par l'équation : D₀ = (n+1) (L_{YA} + L_{YB}) /2.

On réalise alors le masque secondaire présentant des ouvertures secondaires Osᵢ, en éliminant la série de blocs 20_{iB}, comme représenté en figure 4i, laissant à nu localement et de manière alternative des éléments 13i ou 12i et des blocs 20_{iA}.

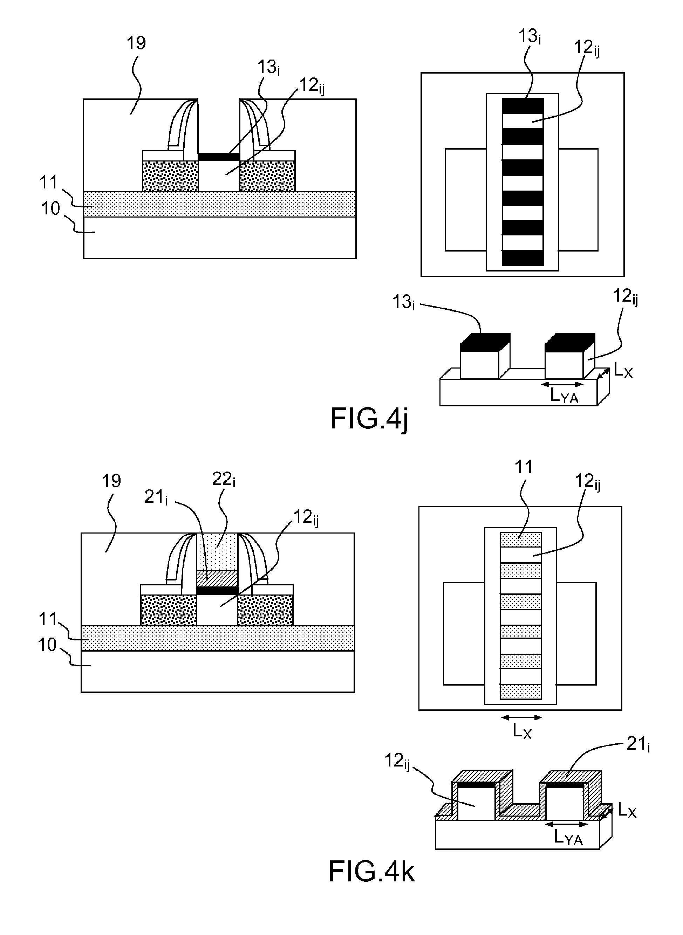

On réalise alors la gravure localement dans la zone dite de canal de la couche de matériau semiconducteur et éventuellement des autres couches telle 13i présentes, de manière à définir des motifs semiconducteurs 12ij de taille nanométrique au moins selon la direction Y, comme représenté en figure 4j.

On vient déposer sur l'ensemble de la zone de canal, une fine couche d'oxyde (sous la couche 21i, comme représenté sur le profil en créneau), typiquement cette couche peut être en SiO₂ ou en HfO₂, ou tout autre oxyde, puis au moins une couche de métal de grille 21i recouverte d'au moins un matériau conducteur comme par exemple un métal ou du silicium polycristallin 22i, comme représenté en figure 4k.

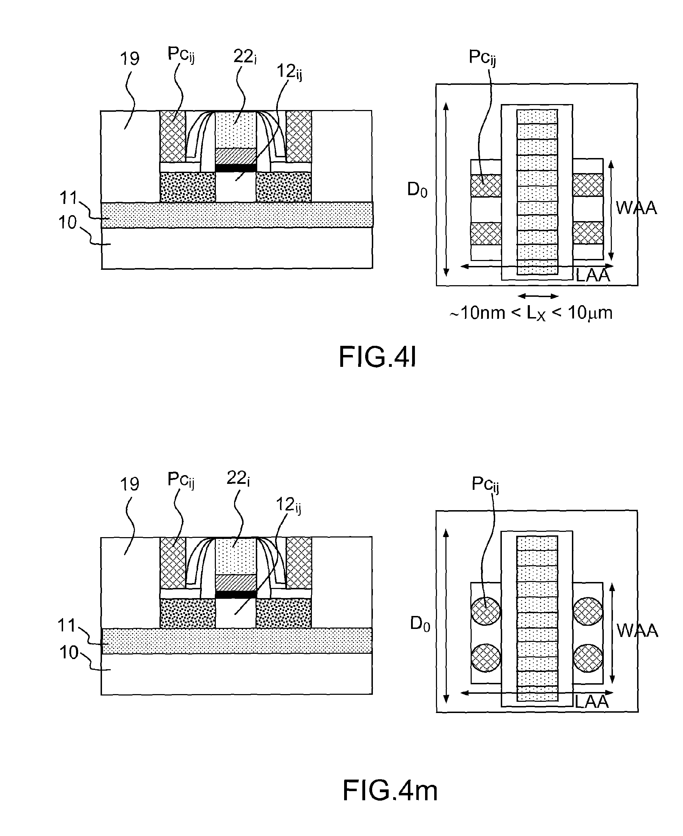

On réalise alors des contacts Pcᵢⱼ, comme illustré en figure 4l ou 4m, permettant de venir commander les nano-grilles ainsi réalisées au niveau des éléments semiconducteurs servant de nano-canaux auto-alignés sur des zones actives définies par les dimensions L_{AA} et W_{AA}. Des techniques connues peuvent être employées pour réaliser ces plots de contact telles que celles décrites dans la littérature et notamment dans la revue : Les Techniques de l'Ingénieur, traité Électronique, au chapitre 4.1.10. p 30. « Transistor MOS et sa technologie de fabrication » de Thomas SKOTNICKI.

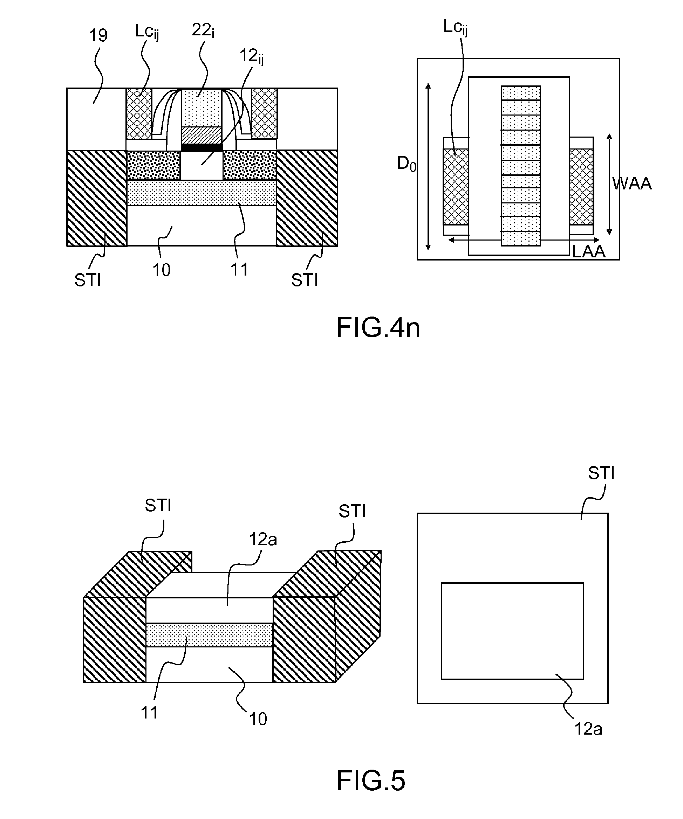

Selon une variante illustrée en figure 4n, les plots Pcᵢⱼ peuvent avantageusement être remplacés par deux bandeaux de contact Lcᵢⱼ et les régions actives 12a peuvent avantageusement avoir été délimitées par des régions isolantes d'oxyde STI couramment dénommées « Shallow Trench Isolation » selon des techniques connues de l'homme de l'art.

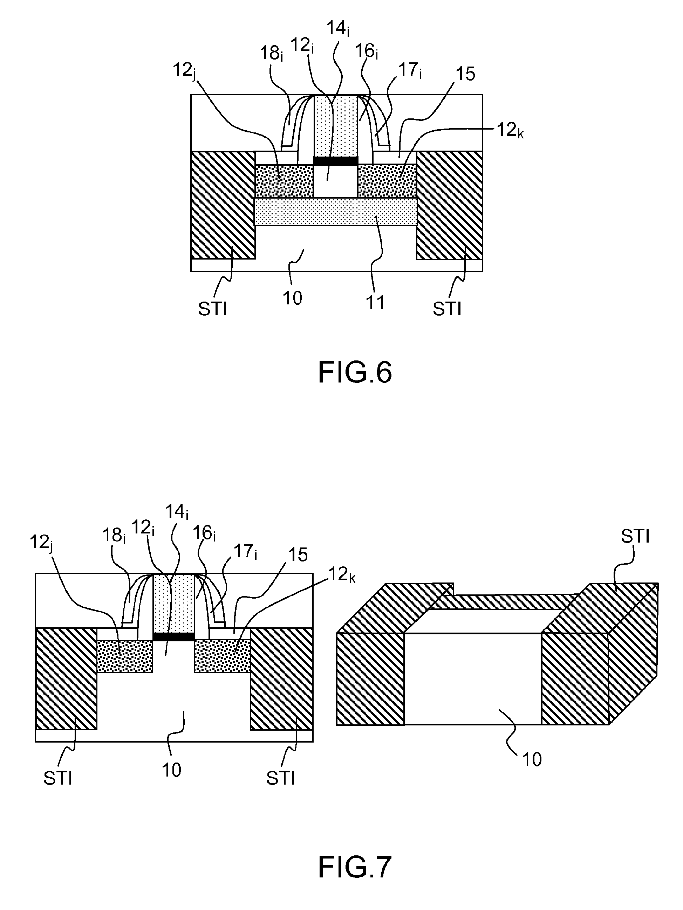

Le procédé de réalisation d'un transistor a été décrit précédemment en limitant les zones actives par gravure, comme illustré en figure 4b. La délimitation de la zone active peut tout aussi bien être réalisée par des tranchées d'oxyde STI, comme illustré en figure 5, la profondeur des motifs STI pouvant conduire ainsi à délimiter ainsi des zones 12a, pouvant être dans le prolongement de la couche 11 et du substrat 10. La structure de transistor réalisée est dans ce cas celle illustrée en figure 6.

Le précédent exemple de transistor décrit est relatif à un transistor de type FDSOI, un autre exemple de transistor pouvant tout aussi bien trouver application dans la présente invention est illustré par une vue en coupe en figure 7, et comprend directement une zone active définie dans le substrat de silicium 10. Selon cet exemple, la zone active est également délimitée par des éléments STI.

## Revendications

1. Procédé de fabrication d'au moins un transistor comportant une zone active semiconductrice sur ou dans un substrat, ladite zone active semiconductrice comprenant une zone de source, une zone de drain et une zone de canal recouverte d'une grille permettant la circulation d'un courant entre la zone de source et la zone de drain selon une première direction X **caractérisé en ce qu'il** comprend :
- la réalisation d'un masque de gravure primaire à la surface de la zone semiconductrice, ledit masque présentant au moins une ouverture primaire (Opᵢ) de dimensions Lₓ et L_{y} dans un plan défini par une première direction X et par une seconde direction Y, parallèles au plan de ladite zone semiconductrice ;
- le dépôt d'un copolymère bloc présentant une alternance d'au moins des premiers motifs de polymère (A) et des seconds motifs de polymère (B) dans ladite ouverture primaire, lesdits premiers et seconds motifs de polymère étant respectivement de dimensions Lₓ et L_{yA} et Lₓ et L_{yB}, les dimensions L_{yA} et L_{yB} étant des dimensions nanométriques ;
- le retrait d'une des séries de premiers motifs ou de seconds motifs de polymère de manière à créer un masque secondaire présentant des ouvertures secondaires (Osᵢ) réparties selon la seconde direction Y ;
- la gravure de ladite zone active au travers desdites ouvertures secondaires de manière à définir les motifs auto-alignés semiconducteurs dans la zone de canal selon la seconde direction Y (12ij) de taille nanométrique de dimensions Lₓ et L_{yA} ou Lₓ et L_{yB}, répartis le long de ladite seconde direction Y ;
- la réalisation de ladite grille à la surface desdits motifs auto-alignés semiconducteurs.

2. Procédé de fabrication d'au moins un transistor selon la revendication 1, **caractérisé en ce que** la réalisation du masque primaire comprend les étapes suivantes :
- la réalisation d'au moins un motif primaire (13i, 14i) à la surface de ladite zone active;
- la réalisation d'espaceurs diélectriques (16i) en contact avec ledit motif primaire ;
- le retrait dudit motif primaire par gravure sélective par rapport aux espaceurs diélectriques, lesdits espaceurs diélectriques définissant ledit masque primaire avec au moins ladite ouverture primaire (Opᵢ).

3. Procédé de fabrication d'au moins un transistor selon l'une des revendications 1 ou 2, **caractérisé en ce que** la zone active est en silicium, ou en silicium-germanium, ou en germanium ou en matériau de type III-V pouvant être du InGaAs ou du InAs.

4. Procédé de fabrication d'au moins un transistor selon l'une des revendications 1 à 3, **caractérisé en ce que** la zone active est réalisée dans une couche de matériau semiconducteur (12) pouvant être en silicium à la surface d'une couche d'oxyde (11) à la surface d'un substrat (10) pouvant être en silicium.

5. Procédé de fabrication d'au moins un transistor selon l'une des revendications 1 à 4, **caractérisé en ce que** la zone active est réalisée dans un substrat massif de matériau semiconducteur.

6. Procédé de fabrication d'au moins un transistor selon l'une des revendications 1 à 5, **caractérisé en ce que** le copolymère est un copolymère dibloc composé de polystyrène (PS) et de poly (méthylméthacrylate) (PMMA).

7. Procédé de fabrication d'au moins un transistor selon l'une des revendications 1 à 6, **caractérisé en ce qu'il** comporte une étape de dépôt(s) d'oxyde(s) de grille, dont un dépôt d'oxyde de grille peut être réalisé de manière conforme sur lesdits motifs semiconducteurs,

8. Procédé de fabrication d'au moins un transistor selon la revendication 7, **caractérisé en ce qu'il** comprend le dépôt d'une couche de métal de grille (21i) sur l'oxyde de grille, sur lesdits motifs auto-alignés semiconducteurs dans la zone de canal.

9. Procédé de fabrication d'au moins un transistor selon la revendication 8, **caractérisé en ce qu'il** comprend le dépôt d'un matériau épais conducteur pouvant être en métal ou en silicium polycristallin (22i) à la surface de ladite couche de métal de grille.

10. Procédé de fabrication d'au moins un transistor selon l'une des revendications 2 à 6, **caractérisé en ce qu'il** comporte :
- le dépôt d'oxyde de grille (13i) sur ladite zone active au niveau de ladite zone de canal ;
- la réalisation d'au moins un motif primaire (13i, 14i) à la surface de ladite zone active;
- la réalisation d'espaceurs diélectriques (16i) en contact avec ledit motif primaire ;
- le retrait dudit motif primaire par gravure sélective par rapport aux espaceurs diélectriques, lesdits espaceurs diélectriques définissant ledit masque primaire avec au moins une ouverture primaire, ladite ouverture primaire étant située sur ledit oxyde de grille.

11. Procédé de fabrication d'au moins un transistor selon la revendication 10, **caractérisé en ce qu'il** comprend le retrait dudit oxyde de grille et le dépôt postérieur d'un oxyde de grille réalisé de manière conforme sur lesdits motifs semiconducteurs auto-alignés.

12. Procédé de fabrication d'au moins un transistor selon l'une des revendications 1 à 11, **caractérisé en ce qu'il** comprend une étape de définition de ladite zone active destinée à correspondre à l'ensemble zone de source, zone de canal et zone de drain, par gravure dans un substrat massif de semiconducteur ou dans une couche semiconductrice à la surface d'une couche d'oxyde (BOX) à la surface d'un substrat.

13. Procédé de fabrication d'un transistor selon l'une des revendications 1 à 11, **caractérisé en ce qu'il** comprend la réalisation de motifs de matériau isolant (STI), afin de définir ladite zone semiconductrice comprenant la zone de source, de la zone de drain et des motifs semiconducteurs auto-alignés recouverts, dans un substrat semiconducteur ou dans une couche semiconductrice à la surface d'une couche d'oxyde (BOX) à la surface d'un substrat

14. Procédé de fabrication d'un transistor selon l'une des revendications 1 à 13, **caractérisé en ce que** ledit motif primaire est éliminé par gravure chimique.

15. Procédé de fabrication d'un transistor selon l'une des revendications 1 à 14, **caractérisé en ce qu'il** comprend le dépôt d'une couche de matériau isolant, enrobant l'ensemble de la zone de source, de la zone de drain et des motifs semiconducteurs auto-alignés recouverts.

16. Procédé de fabrication d'un transistor selon la revendication 15, **caractérisé en ce qu'il** comprend en outre la réalisation d'un série de plots individuels de contact électrique ou d'un ensemble linéaire de contact électrique au travers de ladite couche de matériau isolant, lesdits plots ou ledit ensemble linéaire de contacts permettant de contacter les sources et drains et commander lesdits motifs semiconducteurs auto-alignés.
